# EUROPÄISCHE PATENTSCHRIFT

(11) **EP 0 352 736 B1**
(45) Veröffentlichungstag und Bekanntmachung des Hinweises auf die Patenterteilung: **16.03.1994**
(21) Anmeldenummer: 89113695.4
(22) Anmeldetag: 25.07.1989
(51) Int. Cl.: H01L 21/311, H01L 21/28, H01L 21/027

(54) **Verfahren zur Erzeugung einer Lackstruktur auf Halbleitermaterial mit einer sich zum Halbleitermaterial verjüngenden Öffnung**
Process for producing a resist structure on semiconductor material with reducing width in direction of the semiconductor material
Procédé pour la réalisation d'une structure de laque sur un matériau semiconducteur ayant une ouverture se rétrécissant vers le matériau semiconducteur

(30) Priorität: 28.07.1988 DE 3825729
(43) Veröffentlichungstag der Anmeldung: 31.01.1990
(73) Patentinhaber: SIEMENS AKTIENGESELLSCHAFT, 80333 München (DE)
(72) Erfinder: Hübner, Holger, Dr., D-8011 Baldham (DE)

(56) Entgegenhaltungen:
- EP-A- 0 370 428
- WO-A-89/02652
- DE-A- 3 215 411
- IEEE TRANSACTIONS ON ELECTRON DEVICES. vol. ED-32, no. 6, Juni 1985, NEW YORK US Seiten 1042 - 1046; P. C. CHAO ET AL: "Electron-beam fabrication of GaAs low noise MESFET's using a new trilayer resist technique"
- IEEE ELECTRON DEVICE LETTERS. vol. EDL-7, no. 2, Februar 1986, NEW YORK US Seiten 69 - 70; H. M. MACKSEY: "GaAs power FET's having the gate recess narrower than the gate"

## Beschreibung

Bei Halbleiterbauelementen ergibt sich in zunehmendem Maße das Erfordernis, auf der Oberfläche eines Halbleiterschichtaufbaues eine Metallisierung aufzubringen, bei der die Kontaktfläche zwischen Halbleitermaterial und Metall möglichst klein ist, andererseits aber möglichst viel Metall zur Verminderung des Zuleitungswiderstandes aufgebracht werden kann. Solche Metallisierungen sind zum Beispiel erforderlich bei der Herstellung von Feldeffekttransistoren für Betrieb in höchsten Frequenzbereichen. Um sehr kleine Gatelängen, insbesondere im Sub-µm-Bereich, mit einer Metallisierung mit möglichst großem Querschnitt versehen zu können, stellt man sogenannte Filz- oder T-Gates her. Sie werden erzeugt durch Bedampfen einer pilzförmigen Lackstruktur mit Metall. Daraus ergibt sich das Problem, eine Lackschicht mit dem geforderten Profil zu strukturieren. IEEE Trans. E. Devs., ED-32, No. 6, Seiten 1042-46, (1985) zeigt ein Verfahren zur Erzeugung eines T-Gates.

Eine gängige Methode, eine Strukturierung des auf Halbleitermaterial aufgebrachten Lackes vorzunehmen, besteht darin, eine Folge von Lackschichten nacheinander aufzubringen, wobei jede Schicht einzeln belichtet und entwickelt wird. Dieses Verfahren hat den Nachteil, daß es eine technisch aufwendige Folge von zueinander justierten Belichtungsschritten erforderlich macht. Die Schwierigkeit der Justage läßt sich dadurch umgehen, daß man eine Folge verschieden empfindlicher Lackschichten aufbringt und diese erst anschließend gleichzeitig belichtet und entwickelt. Die pilzförmige Struktur der Öffnung ergibt sich dabei daraus, daß die oberen, höher empfindlichen Schichten zunehmend überbelichtet werden. Dabei wird allerdings die gewünschte geringe Länge der Kontaktierungsfläche (unter 0,5 µm) wegen der großen Dicke des Lackschichtaufbaus nicht erreicht. Wenn die Oberfläche des Halbleiterschichtaufbaues nicht eben ist, ist es nicht möglich, die erste aufzubringende Lackschicht hinreichend dünn aufzutragen. Das zuerst beschriebene Verfahren ist in diesen Fällen nicht anwendbar.

Aufgabe der vorliegenden Erfindung ist es, ein Verfahren für die Herstellung von Lackstrukturen auf Halbleitermaterial mit einer sich zum Halbleitermaterial hin verjüngenden Öffnung anzugeben. Dieses Verfahren soll ohne aufwendige Justage auskommen und bei nicht ebener Topographie anwendbar sein. Es soll damit möglich sein, Öffnungen in der Lackschichtung herzustellen, die die Oberfläche des Halbleiterschichtaufbaues in Bereichen freilegt, deren Abmessungen sich im Sub-µm-Bereich befinden.

Diese Aufgabe wird mit dem Verfahren mit den Merkmalen des Anspruchs 1 gelöst.

Es folgt eine Beschreibung dieses Verfahrens anhand der Fig. 1 bis 6.

Die Fig. 1 bis 3 zeigen einen Halbleiterkörper mit aufgebrachten Lackschichten, in die ein Fenster geätzt wird, für drei aufeinanderfolgende Ätzschritte.

Fig. 4 und 5 zeigen zwei Verfahrensschritte zur pilzförmigen Erweiterung der geätzten Öffnung.

Fig. 6 zeigt den Halbleiterkörper mit der erfindungsgemäß hergestellten Lackschicht nach dem Aufdampfen von Metall.

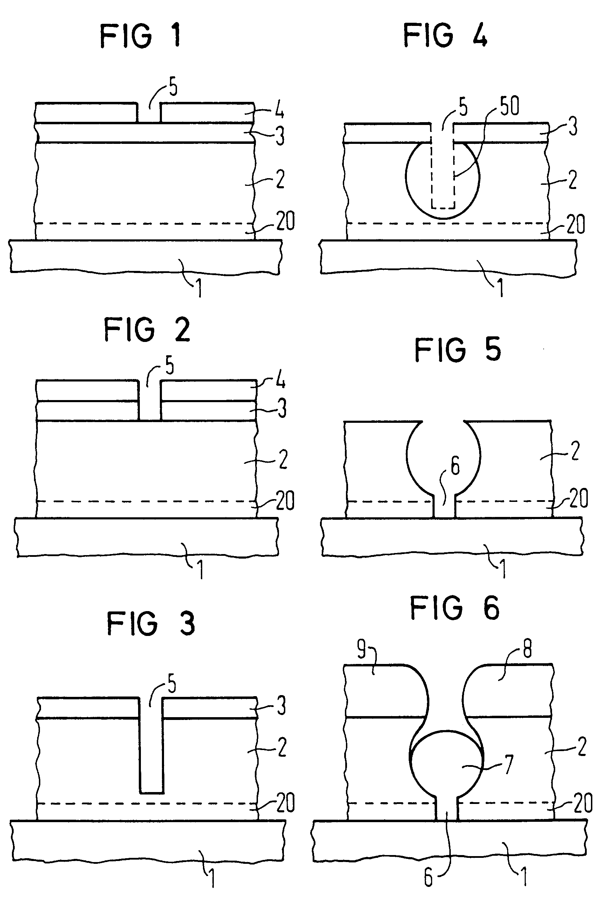

Das erfindungsgemäße Verfahren löst diese Aufgabe, indem die gewünschte Profilform der Lackschicht allein durch reaktives Ionenätzen einer einzigen dicken Lackschicht erreicht wird. In einem ersten Schritt wird auf die Oberfläche des Halbleitermaterials ein Resist 2 aufgebracht. Die Dicke dieser Schicht ist vorteilhaft im Bereich von 600 bis 1000 nm bemessen. Darauf wird in einem zweiten Schritt eine selektiv ätzbare Stoppschicht 3 aus z.B. Siliziumnitrid (Si₃N₄) mit einer Dicke von ungefähr 30 nm aufgebracht. In einem dritten Schritt wird eine obere Lackschicht 4 aus z.B. Polymethylmethacrylat aufgebracht. Diese obere Lackschicht 4 ist wiederum bezüglich der Stoppschicht 3 selektiv ätzbar. Die obere Lackschicht 4 wird in einem vierten Schritt vorstrukturiert, was z.B. mit Elektronenstrahllithographie geschehen kann. Diese Struktur entspricht in ihren Abmessungen dem Bereich, in dem die Halbleiteroberfläche von der Lackschicht freigelegt werden soll. Bei einem Feldeffekttransistor ist diese Struktur entsprechend der Kontaktfläche zwischen Gatebereich und Gatemetallisierung zu bemessen. Den Halbleiterkörper 1 mit Resist 2, Stoppschicht 3, oberer Lackschicht 4 und dem im vierten Verfahrensschritt hergestellten Fenster 5 in dieser oberen Lackschicht 4 zeigt Fig. 1.

In einem fünften Verfahrensschritt wird durch anisotropes Trockenätzen, z.B. mit CF₄-Plasma das Fenster 5 in die Stoppschicht 3 hinein weitergeätzt. Infolge der Anisotropie dieses Ätzschrittes wird die Struktur des Fensters 5 identisch in die Stoppschicht 3 übertragen. Das Ergebnis dieses fünften Verfahrensschrittes ist in Fig. 2 dargestellt.

In einem sechsten Schritt wird durch anisotropes Trockenätzen die durch das Fenster gebildete Struktur tief in den Resist 2 hinein übertragen und gleichzeitig die obere Lackschicht 4 entfernt. Man erhält so den Aufbau aus Fig. 3 mit dem Halbleiterkörper 1, darauf befindlichem, ausgeätztem Resist 2 und der mit dem Fenster 5 strukturierten Stoppschicht 3. Dieser sechste Schritt kann z.B. mit O₂-Plasma erfolgen, was mit dem CF₄-Plasma voll kompatibel ist, so daß durch einfaches Umschalten der Gaszuleitungen von dem fünften in den sechsten Schritt übergeleitet werden kann.

In einem siebenten Schritt wird durch isotropes Trockenätzen der aus dem Resist 2 ausgeätzte Bereich aufgeweitet, wie in Fig. 4 dargestellt. In Fig. 4 ist gestrichelt die Wandung 50 des ursprünglichen Ätzgrabens eingezeichnet. Das Ausweiten der Öffnung in dem Resist 2 wird so ausgeführt, daß sich für Liftoff-Verfahren geeignete obere Kanten in diesem Resist 2 ausbilden.

In einem achten Schritt wird erneut durch anisotropes Trockenätzen der Resist 2 tiefer ausgeätzt, so daß eine Projektion 6 des Fensters in dem dem Halbleiterkörper 1 zugewandten Schichtanteil des Resists 2 erzeugt wird. Wie in Fig. 5 dargestellt ist die Oberfläche des Halbleitermaterials damit freigelegt, und dieser freigelegte Bereich weist genau die Abmessungen der im vierten Schritt des Verfahrens festgelegten Struktur auf. In einem neunten Schritt wird die Stoppschicht 3 entfernt (Fig. 5).

Die auf diese Weise hergestellte strukturierte Lackschicht kann wie in Fig. 6 gezeigt mit Metall bedampft werden. Der erste Anteil 7 der Metallisierung verbleibt auf dem Halbleiterkörper 1, während ein zweiter Anteil 8 und ein dritter Anteil 9 der Metallisierung auf dem Resist 2 mittels Abhebetechnik entfernt werden. Auf diese Weise erhält man die Gatemetallisierungen mit pilzförmigem Querschnitt und hinreichend kurzer Gatelänge.

Als Erweiterung des Herstellungsverfahrens kann vor dem ersten Schritt auf das Halbleitermaterial eine Basisschicht 20 aus Siliziumnitrid aufgebracht werden. Diese Basisschicht 20 kann z.B. für die Herstellung der Halbleiterschichtstruktur des Halbleiterkörpers 1 wie z.B. das Ausheilen von Implantation erforderlich sein und eine Dicke von ungefähr 50 nm aufweisen. In dem neunten Verfahrensschritt wird dann durch anisotropes Ätzen die Projektion 6 des Fensters in die Basisschicht 20 bis zur Oberfläche des Halbleitermaterials hinein geätzt. Dieser Ätzschritt kann auch naßchemisch erfolgen, da dann die Strukturierung des unteren Schichtanteils des Resists 2 als Ätzmaske dient. Eine weitere Abwandlung des Verfahrens kann darin bestehen, daß im sechsten Schritt isotropes Ätzen vorgesehen wird. Es wird dann im sechsten Schritt die obere Lackschicht 4 entfernt und bereits der siebente Schritt in diesem Arbeitsgang mit durchgeführt.

Ein Vorteil des erfindungsgemäßen Verfahrens liegt darin, daß die technischen Möglichkeiten für die Bearbeitung eines dreilagigen Aufbaues hinreichend bekannt sind. Ein weiterer wesentlicher Vorteil ist darin zu sehen, daß bei stark strukturierten, also nicht ebenen Halbleiteroberflächen wegen der möglichen großen Dicke des verwendeten Resists 2 die Topographie eingeebnet werden kann, so daß die obere dünne Lackschicht 4 planar aufgebracht und z.B. mit Elektronenstrahllithographie bequem strukturiert werden kann. Dabei lassen sich Strukturbreiten unter 200 nm erreichen, was bei Strukturierung einer Lackschicht undefinierter Dicke in den tiefer gelegenen Bereichen einer nichtebenen Halbleiteroberfläche nicht möglich wäre. Ein dritter Vorteil des erfindungsgemäßen Verfahrens liegt darin, daß die Struktur von der oberen Lackschicht 4 selbstjustierend durch anisotropes Ätzen bis zur Oberfläche des Halbleitermaterials übertragen wird. Ein vierter Vorteil ist darin zu sehen, daß wegen der hohen Selektivität des Sauerstoffplasmas zwischen dem für die Stoppschicht 3 verwendeten Siliziumnitrid und dem Resist 2 die Struktur dabei ohne meßbaren Unterschied in den Abmessungen übertragen wird. Die Ausweitung des Öffnungsquerschnittes in dem Resist 2 wird allein durch Ändern der Ätzparameter (Druck, Massenfluß, Biasspannung) erreicht. Ein fünfter Vorteil des erfindungsgemäßen Verfahrens besteht darin, daß ein einziger Belichtungs- und Entwicklungsschritt vorgesehen ist. Als sechster Vorteil des Verfahrens ist zu nennen, daß nach der Strukturierung der oberen Lackschicht 4 das weitere Verfahren ohne Unterbrechung in einer Reaktionskammer durchgeführt wird. Das ist möglich, weil das CF₄-Plasma und das O₂-Plasma voll kompatibel sind, so daß die Stoppschicht 3 und der Resist 2 ohne Unterbrechung ätzbar sind. Allenfalls müssen lediglich die Gasleitungen umgeschaltet werden. Ein siebter Vorteil ist, daß eine Basisschicht 20 aus Siliziumnitrid aufgebracht werden kann, die z.B. für den Ausheilprozeß von Implantation erforderlich ist, und diese Basisschicht 20 im gleichen Arbeitsgang, in dem der Resist 2 strukturiert wird, durchgeätzt werden kann. Ein achter wesentlicher Vorteil ist, daß die Formen der Querschnitte der in dem Resist 2 herzustellenden Öffnung in weiten Grenzen wählbar sind, da die erfindungsgemäße Folge von isotropen Ätzschritten in Dauer und Abfolge variierbar ist.

## Patentansprüche

1. Verfahren zur Erzeugung einer Lackstruktur auf Halbleitermaterial mit einer sich zum Halbleitermaterial hin verjüngenden Öffnung,
**dadurch gekennzeichnet,**
- daß in einem ersten Schritt ein Resist (2) aufgebracht wird,
- daß in einem zweiten Schritt eine Stoppschicht (3) aufgebracht wird,
- daß in einem dritten Schritt eine obere Lackschicht (4) aufgebracht wird,
- daß in einem vierten Schritt ein Fenster (5) mit den Abmessungen des Fußes der herzustellenden Öffnung hergestellt wird,
- daß in einem fünften Schritt durch anisotropes Trockenätzen dieses Fenster (5) in die Stoppschicht (3) übertragen wird,
- daß in einem sechsten Schritt durch anisotropes Trockenätzen dieses in der Stoppschicht (3) erzeugte Fenster in den Resist (2) übertragen wird, wobei im Resist (2) ein ausgeätzter Bereich gebildet wird der jedoch nicht die Oberfläche des Halbleitermaterials erreicht, und daß die obere Lackschicht (4) entfernt wird,
- daß in einem siebenten Schritt durch isotropes Trockenätzen der aus dem Resist (2) ausgeätzte Bereich aufgeweitet wird wobei die oberfläche des Halbleitermaterials immer noch nicht freigelegt wird,
- daß in einem achten Schritt durch anisotropes Trockenätzen eine Projektion (6) des Fensters (5) in dem dem Halbleitermaterial zugewandten Schichtanteil des Resists (2) bis zu dessen Grenzfläche hergestellt wird und
- daß in einem neunten Schritt die Stoppschicht (3) entfernt wird.

2. Verfahren nach Anspruch 1,
**dadurch gekennzeichnet,**
- daß der Resist (2) 600 bis 1000 nm dick aufgebracht wird,
- daß die Stoppschicht (3) 20 bis 40 nm dick aufgebracht wird und
- daß die obere Lackschicht (4) 200 bis 400 nm dick aufgebracht wird.

3. Verfahren nach Anspruch 1 oder 2,
**dadurch gekennzeichnet,**
- daß das Halbleitermaterial im wesentichen GaAs ist,
- daß der Resist (2) HPR 204 von Olin Hunt ist und
- daß die obere Lackschicht (4) Polymethylmethacrylat ist.

4. Verfahren nach einem der Ansprüche 1 bis 3,
**dadurch gekennzeichnet,**
- daß vor dem ersten Verfahrensschritt eine Basisschicht (20) aus Siliziumnitrid aufgebracht wird und
- daß in dem neunten Schritt zusätzlich durch anisotropes Ätzen die Projektion (6) des Fensters bis auf die Oberfläche des Halbleitermaterials fortgesetzt wird.

5. Verfahren nach einem der Ansprüche 1 bis 4,
**dadurch gekennzeichnet,**
daß die Stoppschicht (3) Siliziumnitrid ist.

## Claims

1. Process for producing a resist structure on semiconductor material having an opening which narrows in the direction of the semiconductor material, characterized
- in that a resist (2) is applied in a first step,
- in that a stop layer (3) is applied in a second step
- in that an upper resist layer (4) is applied in a third step,
- in that a window (5) having the dimensions of the base of the opening to be made is made in a fourth step,
- in that said window (5) is transferred to the stop layer (3) by anisotropic dry etching in a fifth step,
- in that said window produced in the stop layer (3) is transferred to the resist (2) by anisotropic dry etching in a sixth step, an etched-out region, which does not, however, reach the surface of the semiconductor material, being formed in the resist (2) and in that the upper resist layer (4) is removed,
- in that the region etched out of the resist (2) is widened by isotropic dry etching in a seventh step, the surface of the semiconductor material still not being laid bare,
- in that a projection (6) of the window (5) is made in that layer component of the resist (2) which is adjacent to the semiconductor material down to the boundary surface of the resist (2) by anisotropic dry etching in an eighth step, and
- in that the stop layer (3) is removed a the ninth step.

2. Process according to Claim 1, characterized
- in that the resist (2) is applied in a thickness of 600 to 1000 nm,
- in that the stop layer (3) is applied in a thickness of 20 to 40 nm, and
- in that the upper resist layer (4) is applied in a thickness of 200 to 400 nm.

3. Process according to Claim 1 or 2, characterized
- in that the semiconductor material is essentially GaAs,
- in that the resist (2) is HPR 204 supplied by Olin Hunt, and
- in that the upper resist layer (4) is polymethyl methacrylate.

4. Process according to one of Claims 1 to 3, characterized
- in that a base layer (20) of silicon nitride is applied before the first process step, and
- in that the projection (6) of the window is additionally continued down to the surface of the semiconductor material by anisotropic etching in the ninth step.

5. Process according to any of Claims 1 to 4, characterized in that the stop layer (3) is silicon nitride.

## Revendications

1. Procédé pour former une structure de vernis sur un matériau semiconducteur et ayant une ouverture qui se rétrécit en direction du matériau semiconducteur,
caractérisé par le fait
- que, lors d'une première étape, on dépose une réserve (2),
- que, lors d'une seconde étape, on dépose une couche d'arrêt (3),
- que, dans une troisième étape, on dépose une couche supérieure de vernis (4),
- que, lors d'une quatrième étape, on aménage une fenêtre (5) ayant les dimensions de la base de l'ouverture devant être formée,
- que, lors d'une cinquième étape, en utilisant une gravure anisotrope à sec, on transfère cette fenêtre (5) dans la couche d'arrêt (3),
- que, lors d'une sixième étape, en utilisant une gravure anisotrope à sec, on transfère cette fenêtre aménagée dans la couche d'arrêt (3), dans la réserve (2), une zone dégagée par gravure, qui n'atteint pas cependant la surface du matériau semiconducteur, étant formée dans la réserve (2), et on élimine la couche supérieure de vernis (4),
- que, lors d'une septième étape, en utilisant une gravure isotrope à sec, on élargit la zone dégagée par gravure dans la réserve (2), la surface du matériau semiconducteur n'étant toujours pas encore mise à nu,
- que, lors d'une huitième étape, en utilisant une gravure anisotrope à sec, on forme un prolongement (6) de la fenêtre (5) dans la partie de la réserve (2), qui est tournée vers le matériau semiconducteur, jusqu'à la surface limite de cette réserve, et
- que, lors d'une neuvième étape, on élimine la couche d'arrêt (3).

2. Procédé suivant la revendication 1, caractérisé par le fait
- qu'on dépose la réserve (2) en une épaisseur de 600 à 1000 nm,
- qu'on dépose la couche d'arrêt (3) en une épaisseur de 20 à 40 nm, et
- qu'on dépose la couche supérieure de vernis (4) en une épaisseur de 200 à 400 nm.

3. Procédé suivant la revendication 1 ou 2, caractérisé par le fait
- que le matériau semiconducteur est essentiellement du GaAs,
- que la réserve (2) est du HPR 204 de Olin Hunt, et
- que la couche supérieure de vernis (4) est du poly(méthacrylate de méthyle).

4. Procédé suivant l'une des revendications 1 à 3, caractérisé par le fait
- qu'avant la première étape opératoire, on dépose une couche de base (20) en nitrure de silicium, et
- que, lors de la neuvième étape, on prolonge en supplément, par gravure anisotrope, le prolongement (6) de la fenêtre jusqu'à la surface du matériau semiconducteur.

5. Procédé suivant l'une des revendications 1 à 4, caractérisé par le fait que la couche d'arrêt (3) est du nitrure de silicium.
